# EUROPEAN PATENT SPECIFICATION

(11) **EP 0 420 267 B1**
(45) Date of publication and mention of the grant of the patent: **09.11.1994**
(21) Application number: 90118679.1
(22) Date of filing: 28.09.1990
(51) Int. Cl.: H01L 23/495, H01L 21/56

(54) **Apparatus for producing semiconductor devices**
Apparat zum Herstellen von Halbleiteranordnungen
Appareil pour la production de dispositifs semiconducteurs

(30) Priority: 29.09.1989 JP 254663/89
(43) Date of publication of application: 03.04.1991
(73) Proprietor: KABUSHIKI KAISHA TOSHIBA, Kawasaki-shi, Kanagawa-ken 210 (JP)
(72) Inventor: Kojima, Shinjiro, Chigasaki-Shi, Kanagawa-ken (JP)
(74) Representative: Lehn, Werner, Dipl.-Ing.

(56) References cited:
- EP-A- 0 110 518
- INTERNATIONALE ELEKTRONISCHE RUNDSCHAU, vol. 25, December 1971, pages 301-306,Berlin, DE; H. DELFS: "Hybridschaltungen, Kapselung von Hybridschaltungen"
- NEC RESEARCH AND DEVELOPMENT, no. 91, October 1988, pages 65-71, Tokyo, JP; H.NITTA et al.: "A new type hybrid IC in a transfer-molded standard package"
- 28TH ELECTRONIC COMPONENTS CONFERENCE, Anaheim, CA, 24th - 26th April 1978, pages 213-216; N.A. SOOS et al.: "Encapsulation of large bean leaded devices"

## Description

The present invention relates generally to an apparatus for producing a plurality of resin molded semiconductor devices by an injection molding process. More particularly, the present invention relates to an improvement of the apparatus for producing a plurality of resin molded semiconductor devices wherein molten resin, is injected into a plurality of die cavities on a lower molding die half while a plurality of semiconductor devices such as power hybrid integral circuits each having different kinds of semiconductor elements, e.g., power transistors, diodes or integral circuits mounted on plural kinds of beds each having a different area in a lead frame are placed in the die cavities on the lower molding die half.

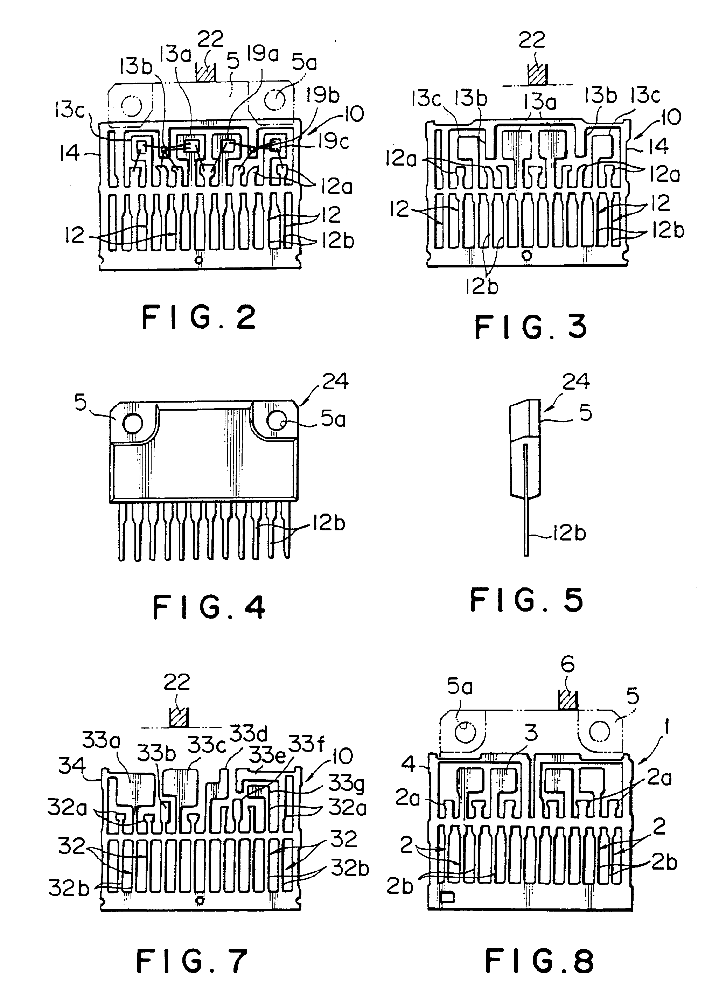

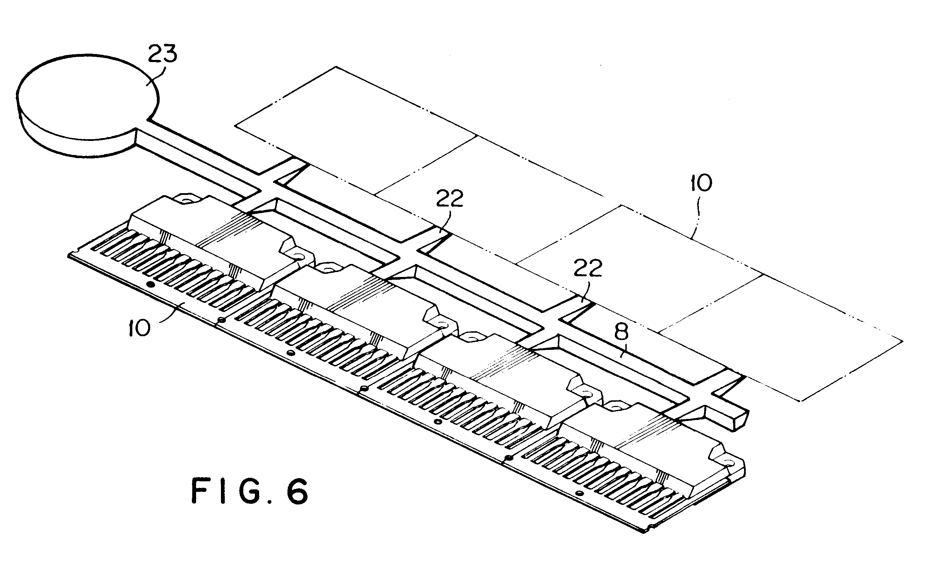

A transistor array of the type which is constructed such that a plurality of beds are arranged on a single lead frame, semiconductor elements are mounted on the beds while the lead frame is placed in the corresponding die cavity on a lower molding die half and molten resin is then injected into each of a plurality of die cavities has been heretofore known as a resin sealed type semiconductor device. This kind of transistor array is typically shown in Fig. 8. As is apparent from the drawing, a lead frame 1 including a single kind of beds 3 each having a same area is used for the transistor array. The lead frame 1 is composed of a plurality of leads 2, a plurality of beds 3 each having same dimensions and an outer frame 4. A plurality of semiconductor elements each having same dimensions are mounted on the beds 3 and electrodes of the semiconductor elements are connected to inner leads 2a of the leads 2 via a number of fine metallic wires. Thereafter, while heat sinks 5 are placed in each die cavity as required, molten resin is injected into a plurality of die cavities on a lower molding die half to provide a plurality of resin sealed type semiconductor devices having outer leads 2b of the leads 2 exposed to the outside.

In general, resin sealing is accomplished using molten resin in such a manner that the lead frame 1 having a plurality of semiconductor elements mounted on the beds is placed in the corresponding die cavity together with heat sinks 5 and others as required and molten resin is then injected into the die cavity. To inject molten resin, a lower molding die half is formed with a plurality of injection gates 6. Generally, each injection gate 6 is located at a position offset leftward or rightward of the central part of the lower molding die half in order to assure that each die cavity is gradually filled with molten resin in the diagonal direction.

In recent years, requests have been increasingly raised for the foregoing kind of resin sealed type semiconductor devices including power transistors each having a different size in a combined state, resin sealed type semiconductor devices including power transistors and diodes in a combined state and resin sealed type semiconductor devices including power transistors, integral circuits and other components in a combined state. These resin sealed type semiconductor devices are put in practical use at a high density in the form of a so-called composite package. With this kind of semiconductor devices, dimensions of each bed on which a semiconductor element is to be mounted vary depending on the kind and the size of a semiconductor element to be mounted.

When a lead frame including plural kinds of beds each having different dimensions is integrally molded with molten resin so as to allow the lead frame to be sealed with the molten resin while the position assumed by each injection gate is left unchanged in the same manner as that of the conventional lead frame regardless of the size of the area occupied by each bed, the molten resin is easy to flow beneath the bed having a small area but it is difficult to flow beneath the bed having a large area, resulting in the bed having a large area failing to be correctly filled with the molten resin. Consequently, there arises a problem that voids remain beneath the bed having a large area.

For example, in a case where a semiconductor device includes heat sinks, once voids remain in the above-described manner, the semiconductor device has a degraded property of electrical resistance between the beds and the heat sinks. Although a property of electrical insulation represented by AC 1500 V X one minute is normally required for the semiconductor device, it is degraded within the range of AC 300 V to 400 V X one minute when the semiconductor device is incorrectly molded in the above-described manner. As a result, the incorrectly molded semiconductor device should be rejected.

The present invention has been made with the foregoing background in mind.

An object of the present invention is to provide an apparatus for producing a plurality of resin molded semiconductor devices each having a lead frame arranged for plural kinds of beds each having different dimensions wherein molten resin is completely filled in each die cavity on a lower die half with minimized formation of voids particularly beneath the bed having a large area and thereby electrical insulation is substantially improved.

To accomplish the above object, the present invention provides an apparatus for producing a plurality of resin molded semiconductor devices by an injection molding process wherein different kinds semiconductor elements are mounted on a single lead frame (10) having a plurality of beds of different sizes and inner leads bonded via a plurality of fine metallic wires to electrodes of said semiconductor elements, the apparatus comprising a lower molding die half having a plurality of die cavities, each die cavity being formed to receive one of said lead frames carrying said semiconductor elements, and having further a feeding port, a runner extending through the lower molding die half so that the die cavities are arranged on opposite sides of the runner, and a plurality of injection gates extending from the runner to a corresponding die cavity, the feeding port, the runner and the injection gates allowing molten resin to be fed and injected into each die cavity, and each injection gate being located at a position in the vicinity of that bed or those beds having the largest size.

With the apparatus as constructed in the above-described manner, when molten resin is injected into a plurality of die cavities to provide a plurality of resin sealed semiconductor devices while a lead frame having different kinds of semiconductor elements mounted on the corresponding beds each having different dimensions is placed in each die cavity, the molten resin is first filled in a region of the die cavity beneath the bed having a larger area. This reliably prevents voids from remaining beneath the bed having a large area after completion of the injection molding operation.

Therefore, according to the present invention, a rate of production of unacceptable resin molded semiconductor devices represented by a property of electrical insulation, e. g., lower than AC 1500 V X one minute can remarkably be reduced merely by changing the position to be assumed by each injection gate without modification of a configuation and dimensions of the injection gate. Thus, a required property of electrical resistance can be obtained with a lead frame having a plurality of beds each having a different area combined therewith, whereby the scope of application of the resin molded semiconductor devices can be widened substantially.

Other objects, features and advantages of the present invention will become apparent from reading of the following description which has been made in conjunction with the accompanying drawings.

The present invention is illustrated in the following drawings in which:
Fig. 1 is a plan view which illustrates a lower molding die half prior to an injection molding operation with heat sinks and lead frames placed in the corresponding die cavities;
Fig. 2 is a plan view which illustrates a single lead frame to be placed in a die cavity on the lower molding die half after completion of a wiring operation;
Fig. 3 is a plan view which illustrates the lead frame prior to the wiring operation and moreover illustrates a positional relationship of an injection gate relative to the lead frame;
Fig. 4 is a plan view of a resin molded semiconductor device after completion of the injection molding operation;
Fig. 5 is a side view of the resin molded semiconductor device in Fig. 4;
Fig. 6 is a perspective which illustrates a resin molded product removed from the lower molding die half;
Fig. 7 is a plan view which illustrates a ingle lead frame to be placed in a die cavity on the lower molding die half which is used for an apparatus for producing a plurality of resin molded semiconductor devices in accordance with another embodiment of the present invention and moreover illustrates a positional relationship of an injection gate relative to the lead frame; and
Fig. 8 is a plan view which illustrates a conventional lead frame to be placed in a die cavity on the lower molding die half and moreover illustrates a positional relationship of an injection gate relative to the lead frame.

Now, the present invention will be described in detail hereinafter with reference to the accompanying drawings which illustrate preferred embodiments of the present invention.

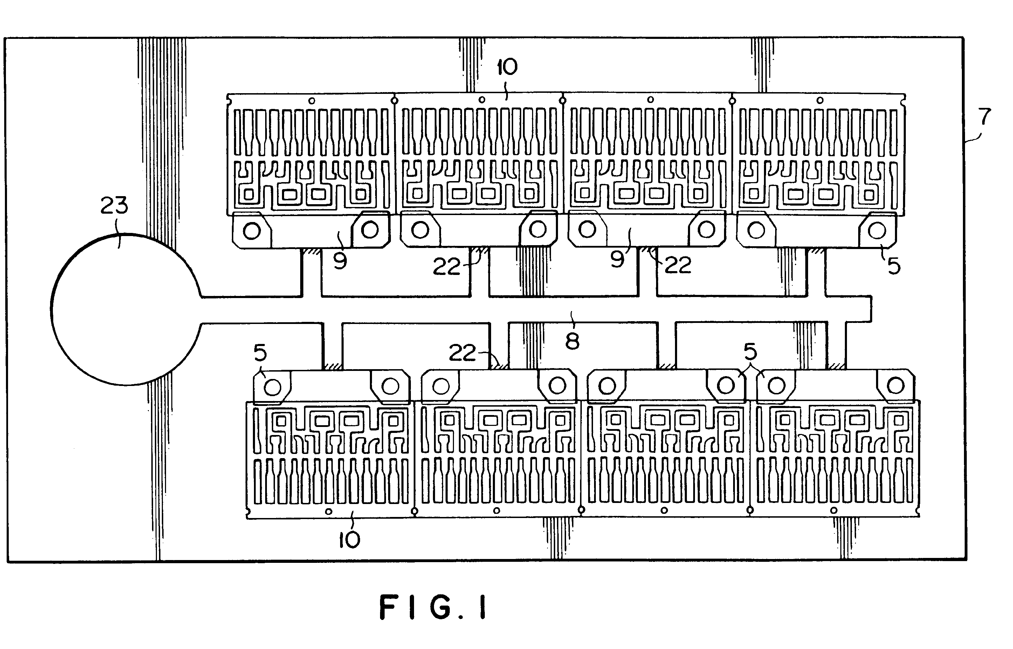

Fig. 1 and Fig. 2 show an apparatus for producing a plurality of resin molded semiconductor devices in accordance with an embodiment of the present invention, respectively. In Fig. 1, reference numeral 7 designates a lower molding die half employable for the apparatus. In this embodiment, the lower molding die half 7 is formed with four molding cavities 9 on opposite sides of a runner 8. Each moldins cavity 9 receives a heat sink 5 and a lead frame 10 therein. As is best seen in Fig. 2, the lead frame 10 includes a plurality of leads 12 comprising inner leads 12a and outer leads 12b, three kinds of symmetrically arranged beds 13a, 13b and 13c each having different dimensions and an outer frame 14.

Specifically, the inner bed 13a located at the central part of the frame 10 and having a largest area is intended to mount a semiconductor element 19a, e.g., a large transistor, the intermediate bed 13b having a smallest area and located adjacent to the bed 13a is intended to mount a semiconductor element 19b, e.g., an integral circuit and the outer bed 13c having an intermediate area is intended to mount a semiconductor 19c, e.g., a small transistor thereon. The beds 13a, 13b and 13c are formed to have dimensions corresponding to those of the semiconductor elements 19a, 19b and 19c to be mounted thereon.

As is apparent from the above description, the lead frame 10 is patterned in consideration of a combination of the semiconductor elements 19a, 19b and 19c to be mounted on the corresponding beds 13a, 13b and 13c. In practice, the lead frame 10 is fabricated by an etching process or a press work.

Thus, plural kinds of semiconductor elements 19a, 19b and 19c are mounted on the corresponding beds 13a, 13b and 13c, and a number of fine lead wires made of metallic material extend between electrodes of the respective semiconductor elements 19a, 19b and 19c as well as between the semiconductor elements 19a, 19b and 19c and inner leads 12a of leads 12 to establish electrical connection therebetween.

In operation, the heat sink 5 is first received in the die cavity 9 and the lead frame 10 for which a wiring operation has been performed is then received in the die cavity 9 on the lower molding die half 7.

In view of the fact that the beds 13a each having a largest area and arranged symmetrically relative to the lead frame 10 are located at the central part of the lead frame 10, an injection gate 22 for feeding molten resin to be molded such as an epoxy resin is engraved on the die cavity 9 at an intermediate position in the vicinity of the beds 13a. Thus, the molten resin which has been fed via a feeding port 23 is injected into the interior of the die cavity 9 via the runner 8 and the injection gate 22.

The injection gate 22 is typically dimensioned to have a width of 3.0 to 4.0 mm and a depth of 0.3 to 0.5 mm.

Since the injection gate 22 is located in the vicinity of the beds 13a each having a largest area, the fed molten resin is fully filled in the die cavity 9 without undesirable formation of voids below each bed 13a.

When the injection gate 22 is located at the central part of the die cavity 9 in the above-described manner, the fed molten resin downwardly expands toward opposite ends of the die cavity 9 in rightward/leftward directions, i.e., flows in opposite directions. In a case of the resin molded semiconductor devices of the aforementioned type, it is important that the die cavity is reliably filled with the fed molten resin without voids remaining below the respective beds. In addition, since the fine metallic wires generally have a diameter larger than that of each lead wire usually employed for an integral circuit, there is no possibility that they flow away during the injection molding operation.

Consequently, a resin molded semiconductor device 24 as shown in Fig. 4 and Fig. 5 is obtainable.

Fig. 7 shows a lead frame which is used for an apparatus for producing a plurality of resin molded semiconductor devices in accordance with another embodiment of the present invention.

In contrast with the first-mentioned embodiment, according to this embodiment, a lead frame 10 includes a plurality of leads 32 comprising inner leads 32a and outer leads 32b, plural kinds of beds 33a, 33b, 33c, 33d, 33e, 33f and 33g each having a different area corresponding to the kind and the size of a semiconductor element, e.g., a transistor, an integral circuit or a diode to be mounted thereon and an outer frame 34.

To assure that an injection molding operation is reliably performed without voids remaining below the beds 33a and 33b each having a largest area among the beds 33a, 33b, 33c, 33d, 33e, 33f and 33g, an injection gate 22 is engraved on the lower molding die half 7 at the position in the vicinity of the beds 33a and 33b.

In contrast with the conventional lead frame which has been described above with reference to Fig. 8 wherein the injection gate is engraved at the position offset to the right-hand side as viewed in the drawing with the result that unacceptable products each having a property of electrical insulation lower than AC 1500 V X one minute are molded at a rate of 2 to 3 %, since the injection gate 22 is engraved in the vicinity of the beds 33a and 33b each having a large area so as to allow the frame 10 to be fully filled with the injected molten resin to provide a plurality of resin molded semiconductor devices in the above-described manner in accordance with this embodiment, it has been confirmed that the reject rate can remarkably be reduced to a level of 0.1 to 0.2 %.

While the illustrated embodiments have been described above with respect to the semiconductor devices each including heat sinks 5, it should of course be understood that the present invention should not be limited only to these embodiments but it may equally applied to semiconductor devices each including no heat sink.

Reference signs in the claims are intended for better understanding and shall not limit the scope.

## Claims

1. An apparatus for producing a plurality of resin molded semiconductor devices by an injection molding process wherein different kinds of semiconductor elements (19a, 19b, 19c) are mounted on a single lead frame (10) having a plurality of beds (13a, 13b, 13c; 33a, 33b, 33c, 33e, 33f, 33g) of different sizes and inner leads (12a) bonded via a plurality of fine metallic wires to electrodes of said semiconductor elements (19a, 19b, 19c), the apparatus comprising a lower molding die half (7) having a plurality of die cavities (9), each die cavity (9) being formed to receive one of said lead frames (10) carrying said semiconductor elements (19a, 19b, 19c), and having further a feeding port (23), a runner (8) extending through the lower molding die half (7) so that the die cavities (9) are arranged on opposite sides of the runner (8), and a plurality of injection gates (22) extending from the runner (8) to a corresponding die cavity (9), the feeding port (23), the runner (8) and the injection gates (22) allowing molten resin to be fed and injected into each die cavity (9), and each injection gate (22) being located at a position in the vicinity of that bed or those beds (13a, 13b; 33a, 33b, 33c, 33d) having the largest size.

2. An apparatus according to claim 1 wherein each lead-frame (10) comprises a pair of beds (13a, 13b) having the largest size and wherein each of said injection gates (22) is located at a position intermediate said pair of beds (13a, 13b).

## Patentansprüche

1. Vorrichtung zum Erzeugen einer Vielzahl von harzgeformten Halbleitervorrichtungen durch einen Spritzgußprozess, wobei verschiedene Arten von Halbleitervorrichtungen (19a, 19b, 19c) angbracht sind auf einem einzelnen Zuführungsrahmen (10) mit einer Vielzahl von Betten (13a, 13b, 13c; 33a, 33b, 33c, 33e, 33f, 33g) verschiedener Größen und innere Zuführungen (12a) gebondet sind über eine Vielzahl von feinen metallischen Dähten zu Elektroden der Halbleiterelemente (19a, 19b, 19c), wobei die Vorrichtung eine untere Spritzgußformhälfte (7) umfaßt mit einer Vielzahl von Spritzguß-Formaushöhlungen (9), wobei jede Spritzguß-Formaushöhlung (9) ausgebildet ist, einen der Zuführungsrahmen (10) tragend die Halbleiterelemente (19a, 19b, 19c) zu empfangen, und mit weiterhin einem Zuführungseingang (23), einem Läufer (8), der sich erschreckt die untere Spritzgußformhälfte (7), so daß die Spritzguß-Formaushöhlungen (9) angeordnet sind auf gegenüberliegenden Seiten des Läufers (8), und mit einer Vielzahl von Einspritzgattern (22) sich erstreckend von Läufer (8) zu einer entsprechenden Spritzgußformaushöhlung (9), wobei der Zuführungseingang (23), der Läufer (8) und die Injektionsgatter (22) ermöglchen, daß geschmolzenes Harz eingespeist und gespritzt wird in jede Spritzguß-Formaushöhlung (9) und jedes Injektionsgatter (22) lokalisiert ist in einer Position in der Nähe des Bett oder der Betten (13a, 13b; 33a, 33b, 33c, 33d) mit der größten Größe.

2. Vorrichtung nach Anspruch 1, dadurch gekennzeichnet, daß jeder Zuführungsrahmen (10) ein Paar von Betten (13a, 13b) umfaßt mit der größten Größe und wobei jedes der Einspritzgatter (22) lokalisiert ist in einer Position zwischen dem Paar von Betten (13a, 13b).

## Revendications

1. Appareil pour la fabrication de plusieurs dispositifs à semi-conducteurs moulés en résine par un procédé de moulage par injection, dans lequel divers types d'éléments à semi-conducteurs (19a, 19b, 19c) sont montés sur une grille de connexion (10) unique comportant plusieurs lits (13a, 13b, 13c; 33a, 33b, 33c, 33e, 33f, 33g) ayant des dimensions différentes et comportant des conducteurs intérieurs (12a) reliés via plusieurs fils métalliques fins à des électrodes desdits éléments à semi-conducteurs (19a, 19b, 19c), l'appareil comportant une moitié inférieure (7) de matrice de moulage comportant plusieurs cavités (9) de matrice, les cavités (9) de matrice étant chacune formée pour recevoir une desdites grilles de connexion (10) supportant lesdits éléments à semi-conducteurs (19a, 19b, 19c), et comportant en outre un trou de coulée (23), un chenal (8) s'étendant à travers la moitié inférieure (7) de matrice de moulage, de sorte que les cavités (9) de matrice sont agencées sur les côtés opposés du chenal (8), et plusieurs orifices d'injection (22) s'étendant depuis le chenal (8) vers une cavité (9) de matrice correspondante, le trou de coulée (23), le chenal (8) et les orifices d'injection (22) permettant à la résine fondue d'être coulée et injectée dans chaque cavité (9) de matrice, et chaque orifice d'injection (22) étant positionné au niveau d'un emplacement situé à proximité du lit ou des lits (13a, 13b; 33a, 33b, 33c, 33d) ayant les dimensions les plus grandes.

2. Appareil selon la revendication 1, dans lequel chaque grille de connexion (10) comporte une paire de lits (13a, 13b) ayant les dimensions les plus grandes, et dans lequel chacun desdits orifices d'injection (22) est positionné au niveau d'un emplacement situé entre ladite paire de lits (13a, 13b).
